# EUROPEAN PATENT SPECIFICATION

(11) **EP 2 518 880 B1**
(45) Date of publication and mention of the grant of the patent: **11.09.2019**
(21) Application number: 12165466.9
(22) Date of filing: 25.04.2012
(51) Int. Cl.: H01L 21/8258, H01L 23/00, H01L 27/06, H01L 27/085, H01L 27/092, H02M 7/00

(54) **INTEGRATED POWER STAGE**
INTEGRIERTE STROMSTUFE
ÉTAGE DE PUISSANCE INTÉGRÉE

(30) Priority: 28.04.2011 US 201161480058 P; 23.04.2012 US 201213454039
(43) Date of publication of application: 31.10.2012
(73) Proprietor: Infineon Technologies Americas Corp., El Segundo, CA 90245 (US)
(72) Inventor: Briere, Michael A., Scottsdale, AZ 85266 (US)
(74) Representative: JENSEN & SON

(56) References cited:
- EP-A2- 2 256 799
- JP-A- 2002 057 037
- US-A1- 2006 091 430
- US-A1- 2008 136 390
- US-A1- 2008 179 678
- US-A1- 2009 267 078
- US-A1- 2010 013 452

## Description

### DEFINITION

As used herein, the phrases "III-nitride," "III-nitride material" and similar terms refer to a compound semiconductor that includes nitrogen and at least one group III element including aluminum (Al), gallium (Ga), indium (In), and boron (B), and including but not limited to any of its alloys, such as aluminum gallium nitride (AlxGa(1-x)N), indium gallium nitride (InyGa(1-y)N), aluminum indium gallium nitride (AlxInyGa(1-x-y)N), gallium arsenide phosphide nitride (GaAsaPbN(1-a-b)), aluminum indium gallium arsenide phosphide nitride (AlxInyGa(1-x-y)ASaPbN(1-a-b)), for example. III-nitride material also refers generally to any polarity including but not limited to Ga-polar, N-polar, semi-polar or non-polar crystal orientations. III-nitride material may also include Wurtzitic, Zincblende or mixed polytypes, and single-crystal, monocrystalline, polycrystalline, or amorphous structures.

### BACKGROUND

A power conversion circuit can include a controller stage, a driver stage, and power switches, which may be operatively coupled to deliver power to a load stage. The controller and driver stages can be used to control the power switches and the power switches can be used to provide power to the load stage. The controller stage may be a separate chip or may be integrated into the driver stage or the load stage. The power conversion circuit should be designed to reduce or eliminate parasitics that negatively impact performance of the power conversion circuit. For example, the controller stage, the driver stage, the power switches, and the load stage should be connected so as to avoid long and non-linear connections that can introduce parasitics, such as parasitic resistance, inductance and capacitance. However, the physical arrangement of the controller stage, the driver stage, the power switches and the load stage can limit reduction of parasitics in the power conversion circuit.

US 2008/136390 A1 discloses a power arrangement that includes a monolithically integrated III-nitride power stage having III-nitride power switches and III-nitride driver switches.

US 2010/013452 A1 discloses methods and apparatus for power supply load dump compensation that may operate in conjunction with a power stage system, such as a power stage system comprising a bootstrapped driver circuit and a power stage responsive to the driver circuit.

EP 2 256 799 A2 discloses a monolithic vertically integrated composite device comprises a double sided semiconductor substrate having first and second sides, a group IV semiconductor layer formed over the first side and comprising at least one group IV semiconductor device, and a group III-V semiconductor body formed over the second side and comprising at least one group III-V semiconductor device electrically coupled to the at least one group IV semiconductor device.

US 2008/179678 A1 discloses an arrangement in which both sides of a semiconductor-on-insulator substrate are utilized to form MOSFET structures.

US 2009/267078 A1 discloses a III-N semiconductor device that includes a substrate and a nitride channel layer.

US 2006/091430 A1 discloses a unit cell of a metal-semiconductor field-effect transistor (MESFET) including a MESFET having a source region, a drain region and a gate contact. The gate contact is disposed between the source region and the drain region. The drain region is electrically coupled to the substrate through a contact via hole to the substrate.

### SUMMARY

The present disclosure is directed to an integrated power stageas recited in claim 1. The integrated power stage receives an input voltage on a top side of the integrated power stage and provides an output voltage on an opposite bottom side of the integrated power stage. It is further directed to an integrated power stage including III-Nitride control and sync transistors as recited in claim 11.

### BRIEF DESCRIPTION OF THE DRAWINGS

Figure 1 presents an exemplary functional diagram of an integrated power stage, according to an implementation disclosed in the present application.
Figure 2A presents an exemplary cross-sectional view of an integrated power stage, according to an implementation disclosed in the present application.
Figure 2B presents an exemplary cross-sectional view of an integrated power stage, according to an implementation disclosed in the present application.
Figure 3A presents an exemplary cross-sectional view of an integrated power stage, according to an implementation disclosed in the present application.
Figure 3B presents an exemplary cross-sectional view of an integrated power stage, according to an implementation disclosed in the present application.
Figure 4A presents an exemplary cross-sectional view of an integrated power stage, according to an implementation disclosed in the present application.
Figure 4B presents an exemplary cross-sectional view of an integrated power stage, according to an implementation disclosed in the present application.
Figure 5A presents an exemplary cross-sectional view of an integrated power converter arrangement, according to an implementation disclosed in the present application.
Figure 5B presents an exemplary cross-sectional view of an integrated power converter arrangement, according to an implementation disclosed in the present application.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

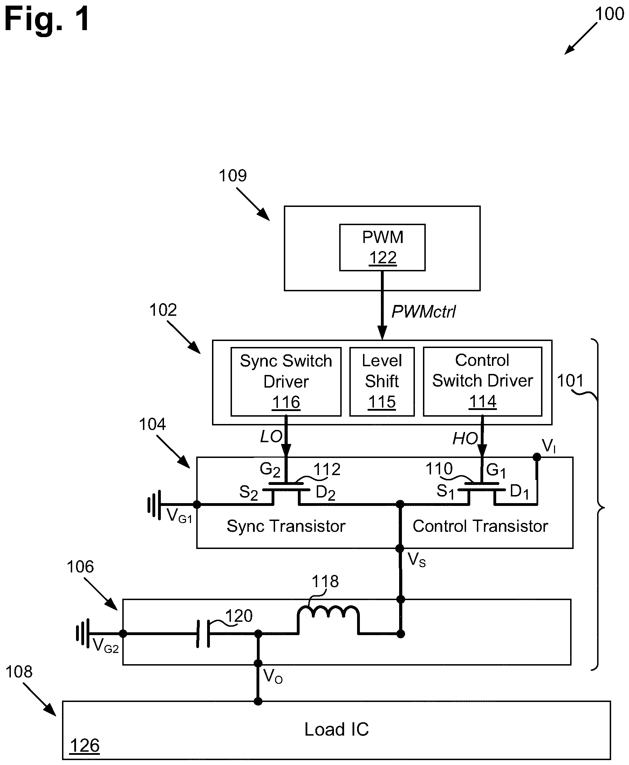

Figure 1 presents an exemplary functional diagram of an integrated power stage, according to an implementation disclosed in the present application. In Figure 1, diagram 100 includes integrated power stage 101 (which can also be referred to as integrated power stack 101) having driver stage 102, power switches 104, and interposer 106. Diagram 100 shows load stage 108 coupled to integrated power stage 101. Additionally, diagram 100 shows controller stage 109 coupled to integrated power stage 101.

Power switches 104 include control transistor 110 and sync transistor 112. Control transistor 110 includes source S₁, drain D₁, and gate G₁. Sync transistor 112 includes source S₂, drain D₂, and gate G₂. In the present implementation, control transistor 110 and sync transistor 112 are arranged in a half-bridge connected between input voltage V_{I} and ground voltage V_{G1} with output voltage V_{S}. In some implementations, input voltage V_{I} is a high voltage input, such as a high voltage supply rail input. Furthermore, ground voltage V_{G1} can be, for example, coupled to a low voltage or ground voltage supply rail. Also, output voltage V_{S} can be a low voltage output.

Also in the present implementation, control transistor 110 and sync transistor 112 are each III-Nitride transistors, such as III-Nitride field-effect transistors (FETs) or III-Nitride high electron mobility transistors (HEMTs). Thus, control transistor 110 is a III-Nitride control transistor and sync transistor 112 is a III-Nitride sync transistor. However, in some implementations, control transistor 110 and/or sync transistor 112 are not III-Nitride transistors.

In certain implementations, control transistor 110 and sync transistor 112 include one or more III-Nitride devices and/or group IV devices. In some implementations control transistor 110 and sync transistor 112 are configured in a cascode configuration. In other implementations, control transistor 110 and sync transistor 112 are each HEMTs, for example III-Nitride HEMTs. In various implementations, any combination of control transistor 110 and sync transistor 112 can be E-mode (enhancement mode) or D-mode (depletion mode) devices.

In some implementations, driver stage 102 (e.g. control transistor 110 and sync transistor 112) is on a silicon substrate, for example, as discussed in U.S. patent number 7,745,849 issued on 06/29/2010 titled "Enhancement Mode III-Nitride Semiconductor Device with Reduced Electric Field Between the Gate and the Drain," U.S. patent number 7,759,699 issued on 07/20/2010 titled "III-Nitride Enhancement Mode Devices," U.S. patent number 7,382,001 issued on 06/03/2008 titled "Enhancement Mode III-Nitride FET," U.S. patent number 7,112,830 issued on 09/26/2006 titled "Super Lattice Modification of Overlying Transistor," U.S. patent number 7,456,442 issued on 11/25/2008 titled "Super Lattice Modification of Overlying Transistor," U.S. patent number 7,339,205 issued on 03/04/2008 titled "Gallium Nitride Materials and Methods Associated with the Same," U.S. patent number 6,849,882 issued on 02/01/2005 titled "Group-III Nitride Based High Electron Mobility Transistor (HEMT) with Barrier/Spacer Layer," U.S. patent number 6,617,060 issued on 09/09/2003 titled "Gallium Nitride Materials and Methods," U.S. patent number 6,649,287 issued on 11/18/2003 titled "Gallium Nitride Materials and Methods," U.S. patent number 5,192,987 issued on 03/09/1993 titled "High Electron Mobility Transistor with GAN/ALXGA1-XN Heterojunctions," U.S. patent number 8,084,785 issued 12/27/2011 titled "III-Nitride Power Semiconductor Device Having a Programmable Gate," U.S. patent application number 12/587,964 filed on 10/14/2009 titled "Group III-V Semiconductor Device with Strain-relieving Interlayers," U.S. patent application number 12/928,946 filed on 12/21/2010 titled "Stress Modulated Group III-V Semiconductor Device and Related Method," U.S. patent application number 11/531,508 filed on 09/13/2006 titled "Process for Manufacture of Super Lattice Using Alternating High and Low Temperature Layers to Block Parasitic Current Path," U.S. patent application number 13/021,437 filed on 2/4/2011 titled "Programmable III-Nitride Transistor with Aluminum-Doped Gate," U.S. patent application number 13/017,970 filed on 1/31/2011 titled "Enhancement Mode III-Nitride Transistors with Single Gate Dielectric Structure," U.S. patent application number 12/653,097 filed on 12/7/2009 titled "Gated AlGaN/GaN Heterojuction Schottky Device," U.S. patent application number 12/195,801 filed on 08/21/2008 titled "Enhancement Mode III-Nitride Device with Floating Gate and Process for Its Manufacture," U.S. patent application number 12/211,120 filed on 09/16/2008 titled "III-Nitride Semiconductor Device with Reduced Electric Field Between Gate and Drain and Process for Its Manufacture," U.S. provisional patent application number 61/447,479 filed on 2/28/2011 titled "III-Nitride Heterojunction Devices, HEMTs and Related Device Structures," and U.S. provisional patent application number 61/449,046 filed on 3/3/2011 titled "III-Nitride Material Interlayer Structures."

In the present implementation, driver stage 102 includes control switch driver 114 providing gate signal HO to control transistor 110 and sync switch driver 116 providing gate signal LO to sync transistor 112. Additionally, driver stage 102 may include other components including level shift 115, driver transistors, logic and protection circuitry, and may also include PWM circuitry. Driver stage 102 can include semiconductor switches, and can be, for example, silicon (Si) based (or more generally group IV based), III-Nitride based, or any combination thereof. In some implementations, for example, as discussed in U.S. patent number 7,863,877 filed on 12/04/2007 titled "Monolithically Integrated III-Nitride Power Converter," driver stage 102 is integrated on a common die with power switches 104. However, in some implementations, driver stage 102 is on a separate die from power switches 104. Similarly, controller stage 109 can be on a separate die, or may be integrated on a common die with driver stage 102 or in some implementations, integrated on a common die with load stage 108.

In some implementations, for example, where control transistor 110 and sync transistor 112 are D-mode devices, driver stage 102 can be provided in accordance with any of U.S. patent number 7,902,809 issued on 03/08/2011 titled "DC/DC Converter Including a Depletion Mode Power Switch," and U.S. patent number 7,839,131 issued on 11/23/2010 titled "Gate Driving Scheme for Depletion Mode Devices in Buck Converters."

In certain implementations, integrated power stage 101 includes interposer 106. However in certain other implementations, interposer 106 is not required. Figure 1 shows load stage 108 receiving output voltage V_{S} of power switches 104 through interposer 106 as interposer output V_{O}. As one example, input voltage V_{I} can be approximately 12 volts and interposer output V_{O} can be approximately 1.5 volt or less. As other examples, input voltage V_{I} can be approximately 8 volts or greater, 24 volts or greater, or 48 volts or greater. Interposer 106 can include one or more output inductors, such as output inductor 118, and in some implementations, can also include one or more output capacitors, such as output capacitor 120. As shown in Figure 1, output inductor 118 is coupled between output voltage V_{S} and load stage 108. Also shown in Figure 1, output capacitor 120 is coupled between output inductor 118 and ground voltage V_{G2}, which can be, for example, coupled to ground voltage V_{G1}. However, in some implementations, interposer 106 does not include output capacitor 120. Interposer 106 can include, for example, one or more interposing materials that may include ferrite or other magnetic material.

In diagram 100, load stage 108 can include, for example, load integrated circuit (IC) 126. In some implementations, load IC 126 includes a central processing unit (CPU), a microprocessor, a graphics processing unit (GPU), a memory IC, a memory array, and/or other circuits. Also, in some implementations, pulse width modulation (PWM) driver 122 (e.g. controller stage 109) is included in load IC 126, for example, as described in U.S. patent number 7,863,877. Figure 1 shows PWM driver 122 providing PWMctrl signal to driver stage 102.

In diagram 100, driver stage 102, power switches 104, interposer 106, and load stage 108 should be designed to reduce or eliminate parasitics that negatively impact performance. For example, driver stage 102, power switches 104, interposer 106, and load stage 108 should be connected so as to avoid long and non-linear connections that can introduce parasitics, such as parasitic resistance, inductance and capacitance. However, the physical arrangement of driver stage 102, power switches 104, interposer 106, and load stage 108 can limit reduction of parasitics in a power conversion circuit. Various implementations described in the present application offer flexibility in the physical arrangement allowing for, for example, reduction of parasitics. In various implementations, for example, input voltage terminal V_{I} is situated on one side (e.g. on a top surface) of integrated power stage 101, and output voltage terminal V_{S} (or interposer output V_{O} if interposer 106 is present) is situated on an opposite side (e.g.on a bottom surface) of integrated power stage 101.

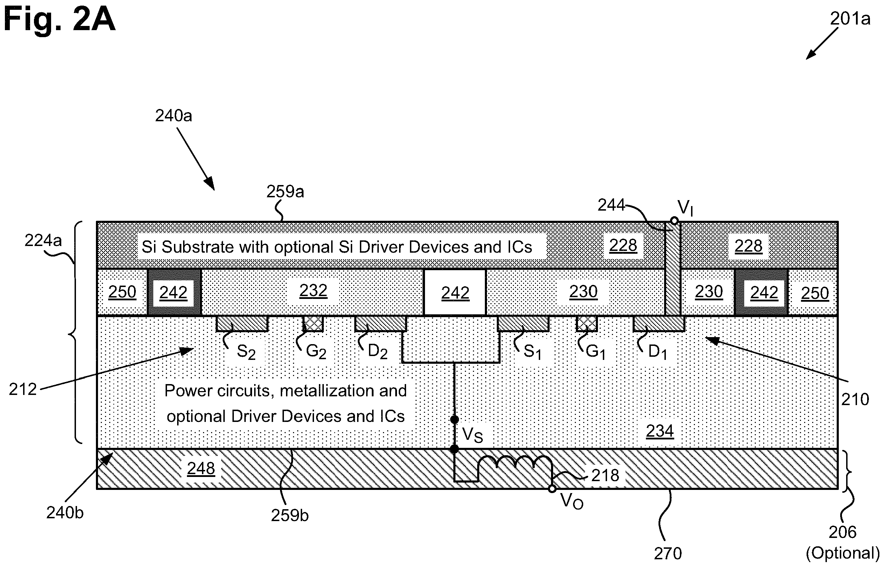

Figure 2A presents an exemplary cross-sectional view of an integrated power stage, according to an implementation disclosed in the present application. More particularly, Figure 2A presents integrated power stage 201a corresponding to integrated power stage 101 in Figure 1.

Integrated power stage 201a includes common die 224a. Integrated power stage 201a also includes interposer 206. In integrated power stage 201a, common die 224a is situated over interposer 206. Common die 224a includes power switches 104 of Figure 1. For example, common die 224a includes control transistor 210 and sync transistor 212 corresponding to control transistor 110 and sync transistor 112 in Figure 1. Figure 1 shows common die 224a including input voltage V_{I} situated on side 240a (more specifically on top surface 260a) and output voltage V_{S} situated on side 240b (more specifically on bottom surface 259b) of common die 224a, corresponding to input voltage V_{I} and output voltage V_{S} in Figure 1. Common die 224a also has ground voltage V_{G1} of Figure 1 (not shown in Figure 2A). Common die 224a further includes substrate 228, control transistor body 230, sync transistor body 232, metallization region 234 (e.g. III-Nitride wafer frontside metallization region 234), and isolation regions 242.

In the present implementation, control transistor 210 and sync transistor 212 are III-Nitride devices. Also in the present implementation, control transistor 210 and sync transistor 212 are on substrate 228 of common die 224a. More particularly, control transistor body 230 and sync transistor body 232 are on substrate 228. In some implementations, control transistor 210 and sync transistor 212 are grown on substrate 228, which can be a silicon (Si) substrate or another type of substrate, such as a semiconductor substrate (e.g., a group IV or a sapphire substrate). Source S₁, Drain D₁, and gate G₁ of control transistor 210 are situated on side 240b of common die 224a. Similarly, source S₂, drain D₂, and gate G₂ of sync transistor 212 are situated on side 240b of common die 224a. Control transistor 210 and sync transistor 212 have active regions isolated by one of isolation regions 242, which can include dielectric material. In some implementations, isolation regions 242 include a trench. Isolation regions 242 can also include conductive material so long as the active regions of control transistor 210 and sync transistor 212 or other regions are sufficiently isolated (for implementations that include isolation regions 242).

As shown in Figure 2A, also in the present implementation, common die 224a includes driver stage 102 of Figure 1. Thus, driver stage 102 is monolithically integrated with power switches 104 in common die 224a. Control switch driver 114 and sync switch driver 116 are coupled to gates G₁ and G₂ respectively, for example, through control transistor body 230 and sync transistor body 232.

In the present implementation, driver stage 102 is on or in substrate 228 and includes Si devices, as shown in Figure 2A. As noted above, while in the present implementation, substrate 228 is a Si substrate, substrate 228 can be a different type of substrate, including a different type of semiconductor substrate. Furthermore, substrate 228 can include different types of devices than the Si devices for driver stage 102. Additionally, driver stage 102 can be included in different portions of common die 224a than substrate 228. For example, driver stage 102 can be completely or partially in epi material 250 (e.g. III-Nitride epi material 250) and/or can be partially in or on substrate 228. Non-limiting examples are disclosed in U.S. patent number 7,915,645 issued on 03/29/2011 titled "Monolithic Vertically Integrated Composite Group III-V and Group IV Semiconductor Device and Method for Fabricating Same."

While in the present implementation, common die 224a includes driver stage 102, in other implementations, driver stage 102 is separate from common die 224a. For example, in some implementations a driver stage die includes driver stage 102 and is situated over common die 224a. However, including driver stage 102 in common die 224a can allow for reduced parasitics as well as reduced size for integrated power stage 201a.

In integrated power stage 201a, drain D₁ of control transistor 210 is receiving input voltage V_{I} of common die 224a on side 240a of common die 224a. There are many ways in which this can be accomplished. For example, a through semiconductor via (TSV) and/or a through-wafer via (TWV) can be utilized. In the present implementation, common die 224a includes input via 244 (which is an input TSV in the present implementation) receiving input voltage V_{I} of common die 224a on side 240a of common die 224a, input via 244 may pass through substrate 228, epi material 250, and/or control transistor body 230, as examples. In the present implementation, input via 244 is coupled to drain D₁ of control transistor 210 and is passing through substrate 228 and control transistor body 230. This may be accomplished using, for example, various methods disclosed in U.S. patent number 6,611,002 issued on 08/26/2003 titled "Gallium Nitride Material Devices and Methods Including Backside Vias," U.S. patent number 7,233,028 issued on 06/19/2007 titled "Gallium Nitride Material Devices and Methods of Forming the Same," U.S. patent number 7,566,913 issued on 07/28/2009 titled "Gallium Nitride Material Devices Including Conductive Regions and Methods Associated with the Same," U.S. patent application number 12/928,103 filed on 12/03/2010 titled "Monolithic Integration of Silicon and Group III-V Devices," and U.S. patent application number 12/174,329 filed on 07/16/2008 titled "III-Nitride Device."

In other implementations, drain D₁ of control transistor 210 is receiving input voltage V_{I} of common die 224a on side 240a of common die 224a utilizing conductive silicon or a group IV substrate for substrate 228. In some implementations, drain D₁ of control transistor 210 is coupled to input voltage V_{I} on the backside of a conductive substrate 228 (which is top surface 259a of common die 224a in the present implementation). For example, input via 244 can pass through control transistor body 230 and extend from drain D₁ of control transistor 210 to contact substrate 228 (e.g., a conductive substrate), or input via 244 can pass through epi material 250 and be electrically connected through topside conductors from drain D₁ of control transistor 210 to contact substrate 228. However, some implementations do not include input via 244.

Also in integrated power stage 201a, source S₁ of control transistor 210 is coupled to drain D₂ of sync transistor 212 and is providing output voltage V_{S} of common die 224a on side 240b (and more specifically bottom surface 259b) of common die 224a. This can be accomplished using various means and is represented by dashed lines in Figure 2A. For example, any combination of conductive vias, layers, and other interconnects can be used, represented within metallization region 234. Figure 2A shows output voltage V_{S} on bottom surface 259b of common die 224a. Bottom surface 259b of common die 224a can be, for example, a surface of control transistor body 230 and sync transistor body 232 or elements thereon.

Thus, as described above, drain D₁ of control transistor 210 is receiving input voltage V_{I} of common die 224a on side 240a (e.g. on top surface 259a) of common die 224a. Furthermore, source S₁ of control transistor 210 is coupled to drain D₂ of sync transistor 212 and is providing output voltage V_{S} of common die 224a on side 240b (e.g. on bottom surface 259b)of common die 224a. Utilizing such an arrangement offers flexibility in the physical arrangement of driver stage 102, power switches 104, and interposer 106 in Figure 1, which can allow for, for example, reduction of parasitics.

Also in Figure 2A, interposer 206 includes output inductor 218, corresponding to output inductor 118 in Figure 1. Output inductor 218 is coupled to output voltage V_{S} of common die 224a on side 240b (e.g. on bottom surface 259b) of common die 224a. Interposer 206 can take various forms. In the implementation shown in Figure 2A, for example, output voltage V_{S} of common die 224a is coupled to interposer 206, which includes interposer material 248. Interposer 206 is on side 240b (and bottom surface 259b) of common die 224a. Interposer material 248 can include a ferritic, or more generally, a magnetic film. In some implementations interposer material 248 is monolithically integrated with power switches 104 and is deposited onto bottom surface 259b, completely covering bottom surface 259b of common die 224a. In other implementations, interposer material 248 partially covers bottom surface 259b of common die 224a. Interposer material 248 can be, for example, approximately 0.5 mm thick. In some implementations, interposer material 248 is greater than or equal to approximately 1.0 mm thick. The thickness of interposer material 248 can be selected based on a function of power switches 104 and conditioning or filtering desired at interposer output V_{O} to load stage 108. In some implementations, additional layers (e.g. a magnetic film) or discrete elements (e.g., an output capacitor) are integrated with interposer material 248 (e.g. a magnetic film) to assist in filtering or conditioning interposer output V_{O}.

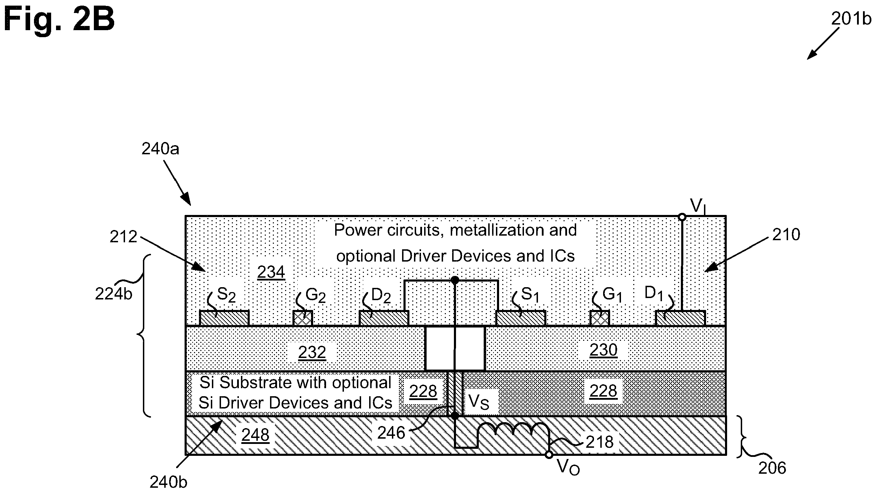

Referring now to Figure 2B, Figure 2B presents an exemplary cross-sectional view of integrated power stage 201b, according to an implementation disclosed in the present application. Integrated power stage 201b is similar to integrated power stage 201a in Figure 2A. However, integrated power stage 201b has a different orientation. In integrated power stage 201b, source S₁, drain D₁, and gate G₁ of control transistor 210 are situated on side 240a of common die 224b. Similarly, source S₂, drain D₂, and gate G₂ of sync transistor 212 are situated on side 240a of common die 224b. Integrated power stage 201b does not have input via 244 receiving input voltage V_{I} of common die 224b on side 240a of common die 224b. Rather, integrated power stage 201b includes output via 246 (which is an output TSV in the present implementation) providing output voltage V_{S} of common die 224b on side 240b of common die 224b. Output via 246 is situated between control transistor 210 and sync transistor 212 in the present example.

In some implementations, output via 246 extends through one of isolation regions 242. In other implementations, output via 246 extends through epi material 250 or control transistor body 230 and/or sync transistor body 232. In some implementations, output via 246 extends completely though common die 224b. In one implementation, output via 246 extends to contact substrate 228, which is a conductive substrate. For example, output via 246 can extend through epi material 250 or through control transistor body 230 and/or sync transistor body 232. However, some implementations do not include output via 246.

As described above with respect to Figure 1, interposer 106 can include one or more output inductors, such as output inductor 118, and in some implementations, can also include one or more output capacitors, such as output capacitor 120. Figures 2A and 2B show one approach to providing interposer 106. Additional approaches are described below.

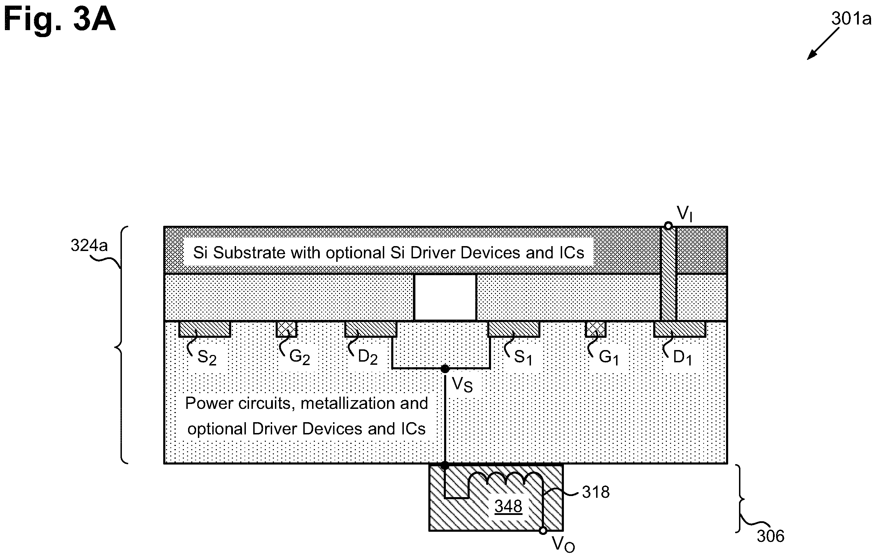

Now referring to Figure 3A, Figure 3A presents an exemplary cross-sectional view of integrated power stage 301a, according to an implementation disclosed in the present application. Integrated power stage 301a includes common die 324a corresponding to common die 224a in Figure 2A.

Integrated power stage 301a also includes interposer 306. Interposer 306 includes output inductor 318 corresponding to output inductor 118 in Figure 1. In integrated power stage 301a, interposer 306 forms lumped element or discrete inductor 348. In some implementations, additional discrete elements are utilized to complete filtering of output voltage V_{S} prior to coupling to load stage 108. The discrete magnetic elements can be connected to common die 324a utilizing solder balls or other approaches (not shown in Figure 3A).

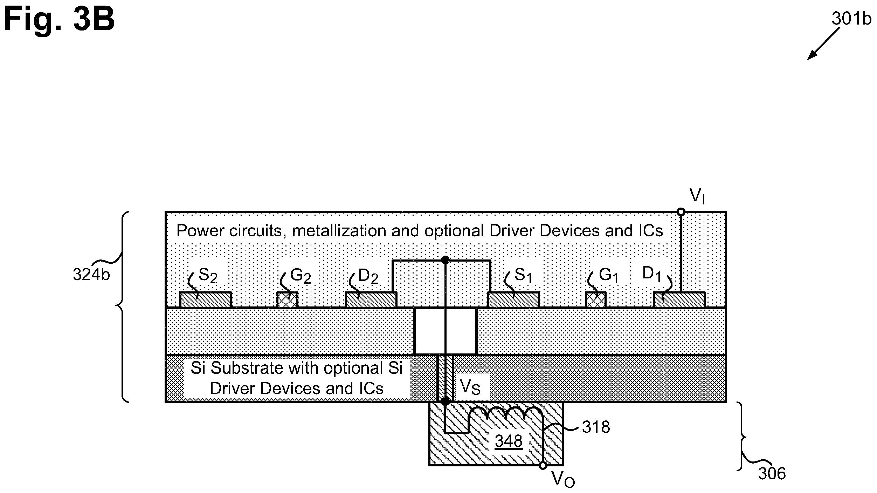

Turning to Figure 3B, Figure 3B presents an exemplary cross-sectional view of integrated power stage 301b, according to an implementation disclosed in the present application. Figure 3B shows integrated power stage 301b including interposer 306. Integrated power stage 301b includes common die 324b corresponding to common die 224b in Figure 2B.

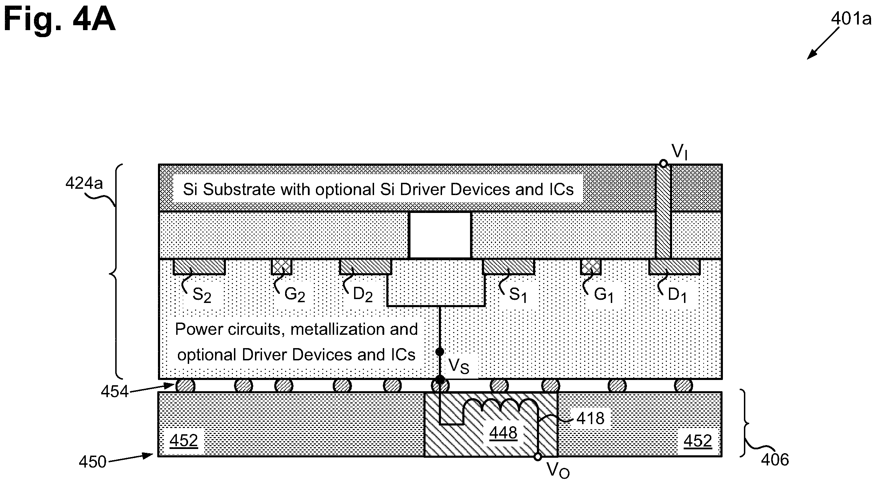

Now referring to Figure 4A, Figure 4A presents an exemplary cross-sectional view of integrated power stage 401a, according to an implementation disclosed in the present application. Integrated power stage 401a includes common die 424a corresponding to common die 224a in Figure 2A.

Integrated power stage 401a also includes interposer 406. Interposer 406 includes output inductor 418 corresponding to output inductor 118 in Figure 1. In integrated power stage 401a, interposer 406 includes interposer die or interposer substrate 450. One example of interposer die 450 is disclosed in U.S. patent application number 12/250,713 filed on 10/14/2008 titled "Interposer for an Integrated DC-DC Converter." In the present implementation, interposer 406 can be formed using ferritic or other magnetic elements (or other materials forming a composite interposer) integrated or embedded into any suitable dielectric material 452. For example, Figure 4A shows lumped element or discrete inductor 448, which can correspond to lumped element or discrete inductor 348 in Figure 3A. Interposer 406 can also include additional components not shown in Figure 4A, for example an output capacitor. Interposer die 450 can be connected to common die 424a, for example, using solder balls 454 or various other approaches.

In some implementations, interposer output V_{O} is coupled to load stage 108. Filtered power from interposer output V_{O} can be coupled to load stage 108 using various approaches. For example, in some implementations, interposer die 450 (or lumped element or discrete inductor 348 or interposer material 248) includes an interposer output contact (e.g. interposer output pad) located on a surface of interposer die 450 (or lumped element or discrete inductor 348 or interposer material 248). In one implementation, the interposer output contact is located on a surface of lumped element or discrete inductor 448, for example, on an inductor). The surface can be a top, bottom, and/or side surface.

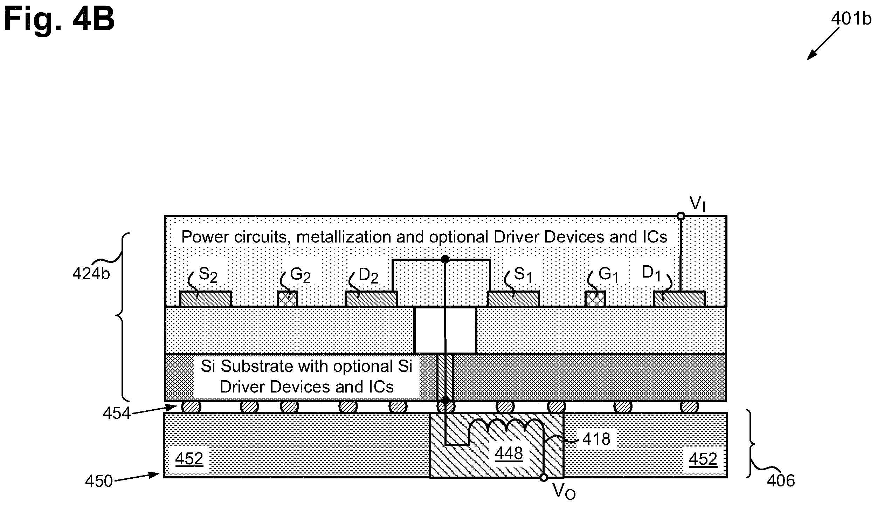

Referring to Figure 4B, Figure 4B presents an exemplary cross-sectional view of integrated power stage 401b, according to an implementation disclosed in the present application. Figure 4B shows integrated power stage 401b including interposer 406. Integrated power stage 401b includes common die 424b corresponding to common die 224b in Figure 2B.

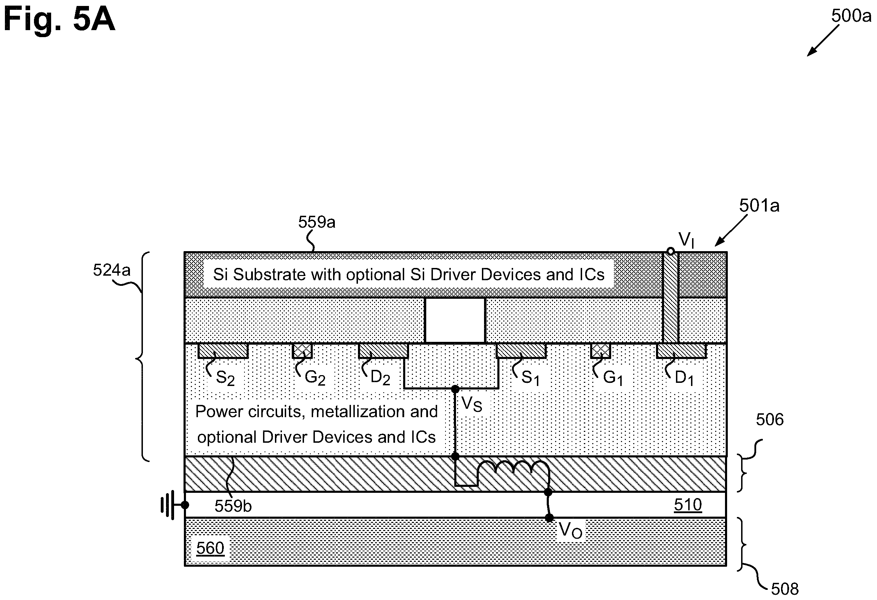

Referring to Figure 5A, Figure 5A presents an exemplary cross-sectional view of integrated power converter arrangement 500a, according to an implementation disclosed in the present application. In Figure 5A, integrated power stage 501a includes common die 524a and interposer 506 corresponding respectively to common die 224a and interposer 206 in Figure 2A. While in the present implementation, interposer 506 corresponds to interposer 206 in Figure 2A, in other implementations, interposer 506 can correspond to any of interposers 306 and 406. Furthermore, interposer 506 can include additional components, such as an output inductor and or an output capacitor. Also in Figure 5A, load stage 508 corresponds to load stage 108 in Figure 1.

In the implementation shown in Figure 5A, interposer 506 is situated over load stage 508. For example, interposer 506 can be over a top surface of load stage 508. In the arrangement shown, input voltage V_{I} enters one side of integrated power stage 501a (e.g. top surface 559a of common die 524a) and output voltage V_{S} exits common die 524a through an opposite side (e.g., bottom surface 559b of common die 524a) and enters a top side/surface of interposer 506. In this example, dielectric layer or film 510 is optionally formed between interposer 506 and load die 560. With dielectric layer 510 grounded, dielectric layer 510 functionally forms an output capacitor (with interposer 506 and load stage 508) with interposer output V_{O} entering a top side/surface of load stage 508, which can include, for example, load die 560 having a load IC. In the present implementation, integrated power converter arrangement 500a can be referred to as an integrated power converter package.

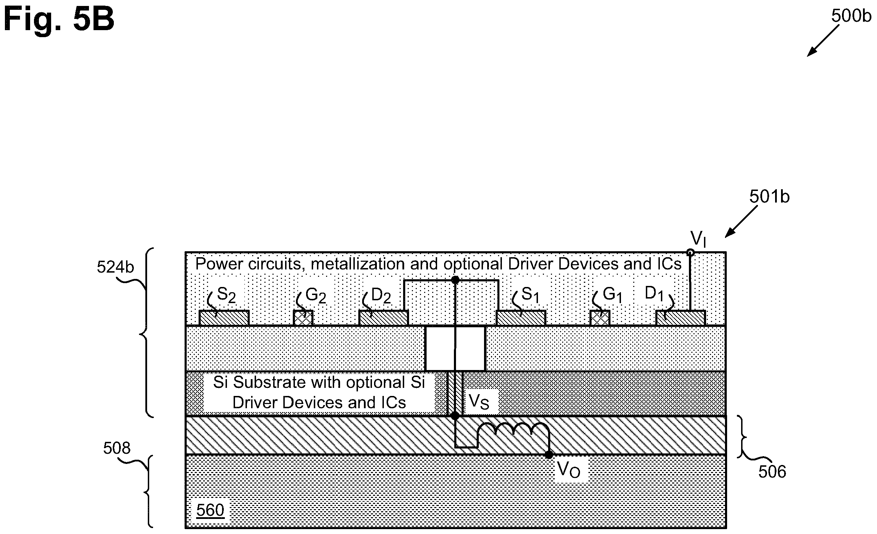

Turning to Figure 5B, Figure 5B presents an exemplary cross-sectional view of integrated power converter arrangement 500b, according to an implementation disclosed in the present application. In Figure 5B , integrated power stage 501b includes common die 524b and interposer 506 corresponding respectively to common die 224b and interposer 206 in Figure 2B . While in the present implementation, interposer 506 corresponds to interposer 206 in Figure 2A , in other implementations, interposer 506 can correspond to any of interposers 306 and 406 and can include an output capacitor, for example, similarly formed by dielectric layer or film 510 in Figure 5A . Similar to Figure 5A , Figure 5B shows load stage 508 corresponding to load stage 108 in Figure 1.

Various implementations of the present disclosure result in highly integrated power converters with reduced parasitics, such as reduced parasitic resistance, inductance and capacitance.

## Claims

1. An integrated power stage (201a) comprising:
a common die (224a) comprising a driver stage (102) and power switches, said power switches including a control transistor (210) and a sync transistor (212);
**characterised by**
a drain of said control transistor (210) receiving an input voltage (V_{I}) of said common die (224a) on a top side (240a) of said common die (224a);
a source of said control transistor (210) coupled to a drain of said sync transistor (212) and providing an output voltage (V_{S}) of said common die (224a) on a bottom side (240b) of said common die (224a).

2. The integrated power stage (201a) of claim 1, further comprising an interposer (206) that includes an output inductor.

3. The integrated power stage (201a) of claim 1, further comprising an interposer (206) that includes an output inductor and an output capacitor.

4. The integrated power stage (201a) of claim 1, wherein said source of said control transistor (210) and said drain of said sync transistor (212) are situated on said top side (240a) of said common die (224a).

5. The integrated power stage (201a) of claim 1 comprising an input via (244) receiving said input voltage of said common die (224a) on said top side (260a) of said common die (224a).

6. The integrated power stage (201a) of claim 1, comprising an output via (246) providing said output voltage of said common die (224a) on said bottom side (240b) of said common die (224a).

7. The integrated power stage (201a) of claim 1, wherein a gate of said control transistor (210) and a gate of said sync transistor (212) are situated on said top side (240a) of said common die (224a).

8. The integrated power stage (201a) of claim 1, further comprising an interposer (206) including an output inductor (218), wherein a load stage is coupled to said output inductor and said interposer is situated over said load stage.

9. The integrated power stage (201a) of claim 1 further comprising an interposer (206) that includes an output inductor, said output inductor coupled to a load stage, said load stage including a central processing unit (CPU), a microprocessor, a graphics processing unit (GPU), or a memory array.

10. The integrated power stage (201a) of claim 1 wherein said driver stage (102) includes a level shifter, a control switch driver, and a sync switch driver.

11. An integrated power stage (201a) comprising:
a common die (224a) situated over a load stage (108), said common die (224a) comprising a driver stage (102) and power switches, said power switches including a III-Nitride control transistor (210) and a III-Nitride sync transistor (212);
**characterised by**
a drain of said III-Nitride control transistor (210) receiving an input voltage (VI) of said common die on a top side (240a) of said common die;
a source of said III-Nitride control transistor (210) coupled to a drain of said III-Nitride sync transistor (212) and providing an output voltage of said common die (224a) on a bottom side (240b) of said common die (224a).

12. The integrated power stage (201a) of claim 11 comprising an interposer that includes an output inductor, said output inductor coupled to said output voltage of said common die on said bottom side of said common die.

13. The integrated power (201a) stage of claim 11, wherein said III-Nitride control transistor (210) and said III-Nitride sync transistor (212) are over a silicon substrate (206) of said common die (224a) .

## Patentansprüche

1. Integrierte Leistungsstufe (201a), umfassend:
einen gemeinsamen Die (224a), der eine Treiberstufe (102) und Leistungsschalter umfasst, wobei die Leistungsschalter einen Steuertransistor (210) und einen Synchronisationstransistor (212) einschließen;
**dadurch gekennzeichnet, dass**
ein Drain des Steuertransistors (210) eine Eingangsspannung (V_{I}) des gemeinsamen Dies (224a) an einer Oberseite (240a) des gemeinsamen Dies (224a) empfängt;
eine Source des Steuertransistors (210) an einen Drain des Synchronisationstransistors (212) gekoppelt ist und an einer Unterseite (240b) des gemeinsamen Dies (224a) die Ausgabespannung (V_{S}) des gemeinsamen Dies (224a) bereitstellt.

2. Integrierte Leistungsstufe (201a) nach Anspruch 1, ferner umfassend einen Interposer (206), der einen Ausgabeinduktor einschließt.

3. Integrierte Leistungsstufe (201a) nach Anspruch 1, ferner umfassend einen Interposer (206), der einen Ausgabeinduktor und einen Ausgabekondensator einschließt.

4. Integrierte Leistungsstufe (201a) nach Anspruch 1, wobei die Source des Steuertransistors (210) und der Drain des Synchronisationstransistors (212) sich auf der Oberseite (240a) des gemeinsamen Dies (224a) befinden.

5. Integrierte Leistungsstufe (201a) nach Anspruch 1, umfassend eine Eingangsdurchkontaktierung (244), die die Eingangsspannung des gemeinsamen Dies (224a) auf der Oberseite (260a) des gemeinsamen Dies (224a) empfängt.

6. Integrierte Leistungsstufe (201a) nach Anspruch 1, umfassend eine Ausgabedurchkontaktierung (246), die die Ausgabespannung des gemeinsamen Dies (224a) auf der Unterseite (240b) des gemeinsamen Dies (224a) bereitstellt.

7. Integrierte Leistungsstufe (201a) nach Anspruch 1, wobei ein Gate des Steuertransistors (210) und ein Gate des Synchronisationstransistors (212) sich auf der Oberseite (240a) des gemeinsamen Dies (224a) befinden.

8. Integrierte Leistungsstufe (201a) nach Anspruch 1, ferner umfassend einen Interposer (206), der einen Ausgabeinduktor (218) einschließt, wobei eine Laststufe an den Ausgabeinduktor gekoppelt ist und der Interposer sich über der Laststufe befindet.

9. Integrierte Leistungsstufe (201a) nach Anspruch 1, ferner umfassend einen Interposer (206), der einen Ausgabeinduktor einschließt, wobei der Ausgabeinduktor an eine Laststufe gekoppelt ist, wobei die Laststufe eine zentrale Verarbeitungseinheit (CPU), einen Mikroprozessor, eine Grafikverarbeitungseinheit (GPU) oder ein Speicher-Array einschließt.

10. Integrierte Leistungsstufe (201a) nach Anspruch 1, wobei die Treiberstufe (102) einen Level-Shifter, einen Steuerschaltertreiber und einen Synchronisationsschaltertreiber einschließt.

11. Integrierte Leistungsstufe (201a), umfassend:
einen gemeinsamen Die (224a), der sich über einer Laststufe (108) befindet, wobei der gemeinsame Die (224a) eine Treiberstufe (102) und Leistungsschalter umfasst, wobei die Leistungsschalter einen III-Nitrid-Steuertransistor (210) und einen III-Nitrid-Synchronisationstransistor (212) einschließen;
**dadurch gekennzeichnet, dass**
ein Drain des III-Nitrid-Steuertransistors (210) eine Eingangsspannung (V_{I}) des gemeinsamen Dies an einer Oberseite (240a) des gemeinsamen Dies empfängt;
eine Source des III-Nitrid-Steuertransistors (210) an einen Drain des III-Nitrid-Synchronisationstransistors (212) gekoppelt ist und an einer Unterseite (240b) des gemeinsamen Dies (224a) eine Ausgabespannung des gemeinsamen Dies (224a) bereitstellt.

12. Integrierte Leistungsstufe (201a) nach Anspruch 11, umfassend einen Interposer, der einen Ausgabeinduktor einschließt, wobei der Ausgabeinduktor an der Unterseite des gemeinsamen Dies an die Ausgabespannung des gemeinsamen Dies gekoppelt ist.

13. Integrierte Leistungsstufe (201a) nach Anspruch 11, wobei der III-Nitrid-Steuertransistor (210) und der III-Nitrid-Synchronisationstransistor (212) sich über einem Siliciumsubstrat (206) des gemeinsamen Dies (224a) befinden.

## Revendications

1. Etage (201a) de puissance intégrée, comprenant :
une puce (224a) commune, comprenant un étage (102) d'attaque et des interrupteurs de puissance, les interrupteurs de puissance incluant un transistor (210) de commande et un transistor (212) de synchronisation ;
**caractérisé par**
un drain du transistor (210) de commande, recevant une tension (V₁) d'entrée de la puce (224a) commune d'un côté (240a) de sommet de la puce (224a) commune ;
une source du transistor (210) de commande couplée à un drain du transistor (212) de synchronisation et procurant une tension (Vₛ) de sortie de la puce (224a) commune d'un côté (240b) de fond de la puce (224a) commune.

2. Etage (201a) de puissance intégrée suivant la revendication 1, comprenant, en outre, un interposeur (206), qui inclut une inductance de sortie.

3. Etage (201a) de puissance intégrée suivant la revendication 1, comprenant, en outre, un interposeur (206), qui inclut une inductance de sortie et un condensateur de sortie.

4. Etage (201a) de puissance intégrée suivant la revendication 1, dans lequel la source du transistor (210) de commande et le drain du transistor (212) de synchronisation sont placés du côté (240a) de sommet de la puce (224a) commune.

5. Etage (201a) de puissance intégrée suivant la revendication 1, comprenant une traversée (244) d'entrée, recevant la tension d'entrée de la puce (224a) commune du côté (260a) de sommet de la puce (224a) commune.

6. Etage (201a) de puissance intégrée suivant la revendication 1, comprenant une traversée (246) de sortie, procurant la tension de sortie de la puce (224a) commune du côté (240b) de fond de la puce (224a) commune.

7. Etage (201a) de puissance intégrée suivant la revendication 1, dans lequel une grille du transistor (210) de commande et une grille du transistor (212) de synchronisation sont placées du côté (24a) de sommet de la puce (224a) commune.

8. Etage (201a) de puissance intégrée suivant la revendication 1, comprenant, en outre, un interposeur (206) incluant une inductance (218) de sortie, un étage de charge étant couplé à l'inductance de sortie et l'interposeur étant placé sur l'étage de charge.

9. Etage (201a) de puissance intégrée suivant la revendication 1, comprenant, en outre, un interposeur (206), qui comprend une inductance de sortie, l'inductance de sortie étant couplée à un étage de charge, l'étage de charge incluant une unité centrale de traitement (CPU), un microprocesseur, une unité de traitement graphique (GPU) ou un réseau de mémoire.

10. Etage (201a) de puissance intégrée suivant la revendication 1, dans lequel l'étage (102) d'attaque comprend un décaleur de niveau, un circuit d'attaque d'un interrupteur de commande et un circuit d'attaque d'un interrupteur de synchronisation.

11. Etage (201a) de puissance intégrée, comprenant :
une puce (224a) commune, placée sur un étage (108) de charge, la puce (224a) commune comprenant un étage (102) d'attaque et des interrupteurs de puissance, les interrupteurs de puissance incluant un transistor (210) de commande au nitrure III et un transistor (212) de synchronisation au nitrure III ;
**caractérisé par**
un drain du transistor (210) de commande au nitrure III, recevant une tension (V₁) d'entrée de la puce (224a) commune d'un côté (240a) de sommet de la puce (224a) commune ;
une source du transistor (210) de commande au nitrure III couplée à un drain du transistor (212) de synchronisation au nitrure III et procurant une tension (Vₛ) de sortie de la puce (224a) commune d'un côté (240b) de fond de la puce (224a) commune.

12. Etage (201a) de puissance intégrée suivant la revendication 11, comprenant un interposeur, qui inclus une inductance de sortie, l'inductance de sortie étant couplée à la tension de sortie de la puce commune du côté de fond de la puce commune.

13. Etage (201a) de puissance intégrée suivant la revendication 11, dans lequel le transistor (210) de commande au nitrure III et le transistor (212) de synchronisation au nitrure III sont sur un substrat (206) en silicium de la puce (224a) commune.
